# EUROPEAN PATENT APPLICATION

(11) **EP 4 631 690 A1**
(43) Date of publication of application: **15.10.2025**
(21) Application number: 23900699.2
(22) Date of filing: 06.12.2023
(51) Int. Cl.: B29B 11/16, C08J 5/24

(54) **PREPREG, LAMINATED PLATE, METAL-CLAD LAMINATED PLATE, PRINTED WIRING BOARD, SEMICONDUCTOR PACKAGE, METHOD FOR MANUFACTURING PREPREG, AND METHOD FOR MANUFACTURING METAL-CLAD LAMINATED PLATE**

(30) Priority: 07.12.2022 JP 2022195966
(71) Applicant: Resonac Corporation, Tokyo 105-7325 (JP)
(72) Inventor: TONOUCHI Shunsuke, Tokyo 105-7325 (JP); KITAJIMA Takayo, Tokyo 105-7325 (JP); MAGOTA Seiya, Tokyo 105-7325 (JP); NAKANISHI Kota, Tokyo 105-7325 (JP)
(74) Representative: Hoffmann Eitle
(86) International application number: PCT/JP2023/043682
(87) International publication number: WO 2024/122587

(57) **Abstract**

Provided is a prepreg which can realize a metal-clad laminate having high thickness accuracy and high insulation reliability even when a fiber substrate having a thickness of 40 µm or more is used. Also provided are a laminate, a metal-clad laminate, a printed wiring board, and a semiconductor package which are obtained by using the prepreg. Also provided are a method for producing the prepreg and a method for producing the metal-clad laminate. The prepreg is a prepreg containing a fiber substrate having a thickness of 40 µm or more and a thermosetting resin composition, in which the prepreg has an impregnated region and a non-impregnated region with the thermosetting resin composition in the fiber substrate, the non-impregnated region exists intermittently, and the prepreg has a surface waviness (Wa) of 5.0 µm or less.

## Description

### Technical Field

The present disclosure relates to a prepreg, a laminate, a metal-clad laminate, a printed wiring board, a semiconductor package, a method for producing a prepreg, and a method for producing a metal-clad laminate.

### Background Art

In association with the increased density of semiconductor packages and the increased communication rate in recent years, a printed wiring board is demanded to have lower warpage, high reliability, and improved impedance controllability. In order to meet this demand, it is necessary to further reduce the thickness variation of the copper-clad laminate as compared with the conventional one. However, a copper-clad laminate produced using a prepreg obtained by a method in which a fiber substrate is immersed in a resin varnish and then dried (see, for example, PTL 1) tends to vary in thickness.

On the other hand, there is known a method for producing a prepreg by preparing a resin film from a thermosetting resin composition in advance instead of immersing a fiber substrate in a resin varnish, and bonding the fiber substrate and the resin film by heating and pressurizing (see, for example, PTL 2). With this method, a prepreg having excellent thickness accuracy can be produced as compared with a method in which a fiber substrate is immersed in a resin varnish. However, as a result of studies by the present inventors, it has been found that when the thickness of the fiber substrate is small, for example, when the thickness is 35 µm or less, the thickness accuracy of the prepreg tends to be excellent, but when the thickness of the fiber substrate is larger than that, the thickness accuracy of the prepreg tends to deteriorate, and the thickness accuracy of the copper-clad laminate sheet tends to deteriorate.

Under such circumstances, a prepreg including a fiber substrate formed in a layer shape and a resin layer provided on at least one surface side of the fiber substrate and composed of a resin composition, in which a void layer not impregnated with the resin composition is formed in at least a part of the fiber substrate has been proposed (see PTL 3). As described in Figs. 1 to 3 and paragraph [0022] of PTL 3, since the void layer communicates from one end to the other end, air is easily released when the prepreg is laminated, and air bubbles are hardly generated.

### Citation List

### Patent Literature

PTL 1:JP 01-272416 A
PTL 2:JP 2011-132535 A
PTL 3:JP 2013-180406 A

### Summary of Invention

### Technical Problem

However, according to further studies by the present inventors, it has been found that the metal-clad laminate prepared using the prepreg having a void layer communicating from one end to the other end described in PTL 3 may have insufficient insulation reliability.

Therefore, an object of the present disclosure is to provide a prepreg capable of realizing a metal-clad laminate having high thickness accuracy and high insulation reliability even in the case when a fiber substrate having a thickness of 40 µm or more is used; to provide a laminate, a metal-clad laminate, a printed wiring board, and a semiconductor package, which are obtained by using the prepreg; and to provide a method for producing the prepreg and a method for producing the metal-clad laminate.

### Solution to Problem

As a result of the accumulated studies by the present inventors, it has been found that the object can be achieved by the present disclosure. The present disclosure includes the following embodiments [1] to [13].
[1] A prepreg containing a fiber substrate having a thickness of 40 µm or more and a thermosetting resin composition, in which the prepreg has an impregnated region and a non-impregnated region with the thermosetting resin composition in the fiber substrate, the non-impregnated region exists intermittently, and the prepreg has a surface waviness (Wa) of 5.0 µm or less.
[2] The prepreg according to the item [1], in which the non-impregnated region exists intermittently in an in-plane direction.
[3] The prepreg according to the item [1] or [2], in which the prepreg has an existing ratio of the impregnated region obtained by the following calculation method of 30 to 98%:
   calculation method: a surface of the prepreg is observed with an optical microscope at a magnification of 50 times to obtain a surface observation image; the resulting surface observation image is converted to monochrome mode with image editing software, and saved in BMP (Microsoft Windows Bitmap Image) format; subsequently, the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.
[4] The prepreg according to the item [3], in which the existing ratio of the impregnated region is 50 to 90%.
[5] The prepreg according to any one of the items [1] to [4], in which the fiber substrate has a thickness of 70 to 120 µm.
[6] A laminate including one or more plies of the prepreg according to any one of the items [1] to [5].
[7] A metal-clad laminate including a metal foil and one or more plies of the prepreg according to any one of the items [1] to [5].
[8] A printed wiring board including the laminate according to the item [6] or the metal-clad laminate according to the item [7].
[9] A semiconductor package including the printed wiring board according to the item [8], and a semiconductor element.
[10] A method for producing a prepreg having a surface waviness (Wa) of 5.0 µm or less by impregnating a fiber substrate having a thickness of 40 µm or more with a film of a thermosetting resin composition through lamination, the method including providing in the fiber substrate an impregnated region and a non-impregnated region with the thermosetting resin composition, and allowing the non-impregnated region to intermittently exist.
[11] The method for producing a prepreg according to the item [10], in which the non-impregnated region is allowed to intermittently exist in an in-plane direction.
[12] The method for producing a prepreg according to the item [10] or [11], in which the prepreg has an existing ratio of the impregnated region obtained by the following calculation method of 30 to 98%:
   calculation method: a surface of the prepreg is observed with an optical microscope at a magnification of 50 times to obtain a surface observation image; the resulting surface observation image is converted to monochrome mode with image editing software, and saved in BMP (Microsoft Windows Bitmap Image) format; subsequently, the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.
[13] A method for producing a metal-clad laminate, including disposing metal foils on both surfaces of one ply of a prepreg obtained by the production method according to any one of the items [10] to [12], or on both surfaces of a prepreg laminate including at least one or more plies of the prepreg, and then press-molding.

### Advantageous Effects of Invention

According to the present disclosure, it is possible to provide a prepreg capable of realizing a metal-clad laminate having high thickness accuracy and high insulation reliability even in the case when a fiber substrate having a thickness of 40 µm or more is used, to provide a laminate, a metal-clad laminate, a printed wiring board, and a semiconductor package, which are obtained by using the prepreg, and to provide a method for producing the prepreg and a method for producing the metal-clad laminate.

### Brief Description of Drawings

[Fig. 1] Fig. 1 is a schematic cross sectional view showing one embodiment of a prepreg of the present embodiment.
[Fig. 2] Fig. 2 is a schematic cross sectional view illustrating one embodiment of the prepreg of the present embodiment.
[Fig. 3] Fig. 3 is a schematic cross sectional view showing a prepreg produced by the ordinary method including immersing the fiber substrate in a resin varnish, followed by drying.
[Fig. 4] Fig. 4 is a cross sectional view of a fiber substrate contained in the prepreg of the present embodiment illustrating the thickness of the fiber substrate.
[Fig. 5] Fig. 5 is a surface observation image obtained by converting a surface observation image used in calculation of an existing ratio of an impregnated region into monochrome mode in the prepreg produced in Example 1.

### Description of Embodiments

One embodiment of the present disclosure will be described below, but the present disclosure is not limited to the embodiment described below.

In a numerical range described in the description herein, the lower limit value or the upper limit value of the numerical range may be replaced with a value shown in Examples. The lower limit value and the upper limit value of the numerical range may be optionally combined with the lower limit value and the upper limit value of another numerical range. In the notation of the numerical range "AA to BB", the numerical values AA and BB at both ends are included in the numerical range as the lower limit value and the upper limit value, respectively. In addition, the notation of the numerical range "more than CC to DD" indicates that the range is more than CC and equal to or less than DD.

In the description herein, for example, the description of "10 or more" means 10 and a numerical value exceeding 10, and the same applies to a case where the numerical value is different. Further, for example, the description of "10 or less" means 10 and a numerical value less than 10, and the same applies to a case where the numerical value is different.

In addition, each component and material exemplified in the description herein may be used alone or in combination of two or more kinds thereof, unless otherwise specified. In the description herein, in a case where multiple substances exist for each of the components in the thermosetting resin composition, the content of the component in the thermosetting resin composition means the total amount of the multiple substances existing in the thermosetting resin composition unless otherwise specified.

In the description herein, the "resin component" is defined as all the components of the solid content constituting the thermosetting resin composition except for the inorganic compound, such as the inorganic filler, the flame retardant, and the flame retardant aid, which are described later.

In the description herein, the "solid content" means a component other than a solvent, and a component that is liquid at 25°C is also regarded as a solid content.

The expression "containing XX" described in the description herein naturally means simply containing XX, but also includes containing in a state where what is described in XX has reacted (however, only in a case where it can react).

An aspect in which matters described in the description herein are arbitrarily combined is also included in the present disclosure and the present embodiment.

### [Prepreg]

The prepreg of the present embodiment is a prepreg containing a fiber substrate having a thickness of 40 µm or more and a thermosetting resin composition, in which the prepreg has an impregnated region and a non-impregnated region with the thermosetting resin composition in the fiber substrate, the non-impregnated region exists intermittently, and the prepreg has a surface waviness (Wa) of 5.0 µm or less. It should be noted that the fact that the prepreg has an impregnated region and a non-impregnated region with the thermosetting resin composition in the fiber substrate only relates to the prepreg, that is, the prepreg in a B-stage state, and does not relate to a cured product of the prepreg.

The surface waviness (Wa) in the present disclosure is the arithmetic average height (Wa) that can be obtained from the waviness curve according to ISO 4287 (1997). JIS B0601 (2001) may be used instead of ISO 4287 (1997). The surface waviness (Wa) in the present disclosure can be measured in the following manner.

The shape measurement is automatically performed with the observation application of a shape analysis laser microscope "VK-X100" (manufactured by Keyence Corporation) to provide a waviness curve in accordance with ISO 4287 (1997) or JIS B0601 (2001). The resulting waviness curve is analyzed for the surface roughness with the analysis application to calculate the surface waviness (Wa). The waviness curve herein is a curve obtained by removing a wavelength of less than 80 µm from the cross sectional curve by applying a phase compensation high-pass filter λc (λc = 80 µm) on the cross sectional curve. The analysis region is 1,000 µm × 1,000 µm.

Unless otherwise specified, the surface waviness (Wa) of the prepreg in the present disclosure is the surface waviness of both surfaces of the prepreg, and the "surface" refers to a surface to be overlapped or a surface opposite thereto when a plurality of prepregs are laminated to prepare a metal-clad laminate.

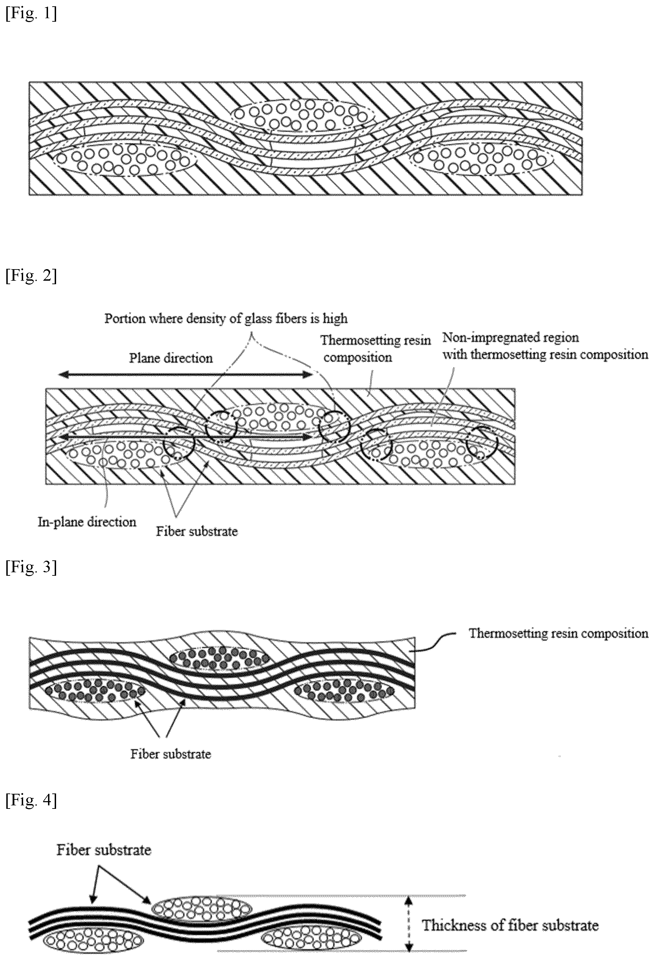

In addition, in the description herein, the "plane direction" of the prepreg means a direction along the plane of the prepreg in the surface of the prepreg as shown in Fig. 2. In addition, in the description herein, the "in-plane direction" means a direction along the surface of the fiber substrate in the inside of the fiber substrate as shown in Fig. 2. Both the "plane direction" and the "in-plane direction" are parallel to a direction nearly perpendicular from one side of the prepreg to a side facing the side. In the description herein, the term "nearly perpendicular" refers to being substantially perpendicular, and is preferably within a range of 86° to 94°, more preferably within a range of 88° to 92°, and still more preferably 90°.

The prepreg of the present embodiment has a surface waviness (Wa) of 5.0 µm or less irrespective of the use of the "fiber substrate having a thickness of 40 µm or more", which has a larger surface waviness than a thin fiber substrate. This has been realized by the method of "intentionally providing a non-impregnated region with the thermosetting resin composition in the fiber substrate of the prepreg". The method is generally difficult to employ in consideration of the ordinary technical common sense in the production of the prepreg that voids are suppressed from occurring by increasing the impregnation rate of the thermosetting resin composition in the fiber substrate as much as possible. By using the prepreg of the present embodiment, the thickness accuracy of the metal-clad laminate of the present embodiment was successfully significantly enhanced.

On the other hand, in the ordinary method of immersing a fiber substrate in a resin varnish, followed by drying, as shown in Fig. 3, the thermosetting resin composition follows the waviness of the glass cloth, and thereby the surface waviness of the prepreg is increased. Accordingly, the thickness variation of the resin layer in the plane direction of the prepreg is increased. While the thermosetting resin composition easily flows in the thickness direction of the prepreg since the prepreg is pressurized in the thickness direction in producing a metal-clad laminate, the insufficient flow thereof in the plane direction leads to the thickness variation of the metal-clad laminate. However, there is technical difficulty in controlling the flow of the thermosetting resin composition in the plane direction to an extent that can reduce or eliminate the thickness variation of the resin layer.

However, the prepreg of the present embodiment has the resin layer in the vicinity of the surface thereof that exists not along the waviness of the glass cloth, and thereby has a small surface waviness, i.e., a small thickness variation, as described above. It is considered accordingly that the thickness variation of the metal-clad laminate is reduced even though the thermosetting resin composition is not allowed to flow in the plane direction in producing the metal-clad laminate.

Further, by "allowing the non-impregnated region to intermittently exist" in the prepreg of the present embodiment, the insulation reliability of the metal-clad laminate of the present embodiment, and thus the insulation reliability of the printed wiring board, can be further improved. It is preferable that the non-impregnated region exists intermittently in the in-plane direction of the fiber substrate.

The mechanism that leads to the success is not clear, but can be considered as follows. As shown in Fig. 1 and Fig. 2, in impregnating a fiber substrate with a resin film, the region that is not impregnated with the thermosetting resin composition is intentionally provided in the fiber substrate, and thereby the layer of the thermosetting resin composition (which may be hereinafter abbreviated as a resin layer) in the vicinity of the surface is allowed to exist not along the waviness of the glass cloth. As a result, the large waviness of the fiber substrate having a thickness of 40 µm or more is prevented from appearing on the surface of the prepreg, and thereby the surface waviness (Wa) of the prepreg is allowed to be 5.0 µm or less. The use of the prepreg having a surface waviness (Wa) of 5.0 µm or less in press-molding suppresses the thickness of the metal-clad laminate from becoming uneven due to the small surface waviness (Wa) of the prepreg, resulting in the achievement of high thickness accuracy.

Then, although the exact reason why the insulation reliability is improved by the fact that the non-impregnated region exists intermittently without communicating from one end to the other end of the prepreg is not clear, it is presumed that this is because the thermosetting resin composition is sufficiently impregnated even in the vicinity of the portion where the density of the fiber substrate is high when the metal-clad laminate is produced. To explain with reference to Fig. 1 and Fig. 2, for example, in a glass cloth, the density of glass fibers is high in a portion where glass yarns are woven and overlapped with each other, and it is considered that voids tend to be present in this portion in a prepreg. When the thermosetting resin composition is not sufficiently impregnated into the portion having a high density of glass fibers in producing a metal-clad laminate, this may lead to insulation failure. On the other hand, in the prepreg of the present embodiment, it is considered that since the portion having a high density of glass fibers is in a state where there are few or no voids and the thermosetting resin composition is sufficiently impregnated into the portion having a high density of glass fibers in the metal-clad laminate, the insulation reliability is improved.

As described in PTL 3, in the case of a prepreg having a void layer communicating from one end to the other end, since the void layer is formed even in a portion where the density of glass fibers is high, the resin is not impregnated, and it is presumed that the thermosetting resin composition is not sufficiently impregnated into the portion where the density of glass fibers is high when the metal-clad laminate is produced, which leads to the result that the insulation reliability is inferior (see Comparative Examples 2 and 3).

In the present embodiment, while the non-impregnated region with the thermosetting resin composition is intermittently provided in the fiber substrate of the prepreg, voids in the metal-clad laminate can be sufficiently suppressed from occurring by allowing the thermosetting resin composition to flow in the thickness direction and run into the non-impregnated region in press molding in the production of the metal-clad laminate.

From the above viewpoint, the surface waviness (Wa) of the prepreg of the present embodiment is preferably 5.0 µm or less, more preferably 3.0 µm or less, and still more preferably 1.0 µm or less. The lower limit value of the surface waviness (Wa) of the prepreg of the present embodiment is not particularly limited, may be 0.01 µm or more, may be 0.1 µm or more, or may be 0.2 µm or more. Accordingly, the surface waviness (Wa) of the prepreg of the present embodiment may be 0.01 to 5.0 µm, may be 0.1 to 3.0 µm, or may be 0.2 to 1.0 µm.

### (Existence of Non-impregnated Region with Thermosetting Resin Composition in Fiber Substrate)

As described above, the prepreg of the present embodiment has an impregnated region and a non-impregnated region with the thermosetting resin composition in the fiber substrate, and is particularly characterized by having the non-impregnated region and the non-impregnated region existing intermittently. The existence of the non-impregnated region can be confirmed by determining the existing ratio of the impregnated region with the thermosetting resin composition in the fiber substrate. Specifically, the existing ratio of the impregnated region that does not reach 100% means the existence of the non-impregnated region.

In the present embodiment, the existing ratio of the impregnated region with the thermosetting resin composition in the fiber substrate is defined as being obtained by the following calculation method. From the viewpoint of the thickness accuracy of the metal-clad laminate, the existing ratio of the impregnated region obtained by the "calculation method" described later may be 30 to 98%, may be 30 to 95%, may be 35 to 95%, may be 40 to 95%, may be 45 to 90%, may be 50 to 90%, may be 55 to 90%, or may be 60 to 85%, while not particularly limited. In a case where the existing ratio is 98% or less, there is a tendency of increasing the effect of improving the thickness accuracy of the metal-clad laminate, and in particular, in a case where the existing ratio is 95% or less, the tendency is further enhanced. In addition, in a case where the existing ratio is 30% or more, powder falling of the thermosetting resin composition from the prepreg is suppressed, and thus a secondary effect of good handleability tends to be obtained. In addition, when the existing ratio of the impregnated region is 30% or more, the non-impregnated region is likely to exist intermittently, and from this viewpoint, the existing ratio of the impregnated region is preferably 50% or more.

### - Calculation Method -

The surface of the prepreg is observed with an optical microscope at a magnification of 50 times to provide a surface observation image. As the observation conditions, the observation conditions described in Examples are adopted in detail from the viewpoint of imaging with suitable brightness.

The resulting surface observation image is converted to monochrome mode with image editing software, and saved in BMP (Microsoft Windows Bitmap Image) format. Subsequently, the surface observation image in monochrome mode saved in BMP format is converted to RGB (red, green, blue) values pixel by pixel with image converting software, and then saved in CSV (comma-separated values) format. The RGB data saved in CSV format is pasted on Microsoft Excel (available from Microsoft Corporation), and calculated for areas of a black part (RGB value = 255) and a white part (RGB value = 0). An area ratio of the black part with respect to the total of the black part and the white part is calculated from the resulting values. The area ratio of the black part obtained is designated as the existing ratio of the impregnated region.

As the image editing software, for example, "Microsoft Paint" (available from Microsoft Corporation) can be used. In addition, as the image conversion software, for example, "bmp2csv", which is a free software, can be used.

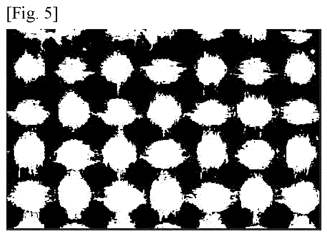

In the observation, in converting the surface observation image imaged under suitable brightness to monochrome mode, the surface having the non-impregnated region with the thermosetting resin composition existing under the observation surface is a gap portion and is easy to reflect light, thus, is expressed in white, and the other surface is expressed in black. The surface observation image is preferably imaged with an exposure time in imaging the surface regulated to a range of 60 to 100 ms since the imaging can be performed under suitable brightness capable of sufficiently representing the impregnated region and the non-impregnated region. On the surface observation image of the prepreg, the "region having no glass cloth in the resin layer", the "region having the glass cloth sufficiently impregnated with the thermosetting resin composition", and the "region having the glass cloth insufficiently impregnated with the thermosetting resin composition" exist in descending order of the color strength. In the present embodiment, the "region having no glass cloth in the resin layer" is also encompassed in the impregnated region. In a case where the surface observation image is too bright, in the surface observation image in monochrome mode, not only the region having the glass cloth insufficiently impregnated with the resin, but also the region having the glass cloth sufficiently impregnated with resin tend to be white, and in a case where the image is further brighter, there is a tendency that the entire surface observation image in monochrome mode becomes white. On the other hand, in a case where the surface observation image is too dark, there is a tendency that the entire surface observation image in monochrome mode becomes black, and the existence of the non-impregnated region is difficult to represent. Accordingly, the imaging is preferably performed under suitable brightness. As an example of a surface observation image imaged under suitable brightness converted to monochrome mode, the surface observation image converted to monochrome mode obtained in Example 1 is shown in Fig. 5. In Fig. 5, it can be observed that the impregnated region and the non-impregnated region are alternately present in the in-plane direction.

The area ratio of the white part with respect to the total of the black part and the white part can be easily calculated by using the COUNTIF function of Microsoft Excel (available from Microsoft Corporation).

### (Non-Impregnated Region)

In the prepreg of the present embodiment, as described above, since the non-impregnated region exists intermittently, the insulation reliability of the metal-clad laminate is improved. Since the non-impregnated region with the thermosetting resin composition exists intermittently in the fiber substrate of the prepreg, it is considered that the thermosetting resin composition is present as close as possible to the portion where the density of the glass cloth is high and the thermosetting resin composition is difficult to enter. Therefore, it is considered that the insulation reliability is improved by suppressing the occurrence of fine voids by the thermosetting resin composition rapidly flowing to the portion where the density of the glass cloth is high and the thermosetting resin composition is difficult to enter during press molding. On the other hand, if the non-impregnated region with the thermosetting resin composition is continuously present in the fiber substrate of the prepreg, it is considered that the thermosetting resin composition is present at a portion away from the portion where the density of the glass cloth is high and the thermosetting resin composition is difficult to enter. Therefore, although the thermosetting resin composition flows during press molding, it is considered that curing proceeds before the thermosetting resin composition flows to the portion where the density of the glass cloth is high and the thermosetting resin composition is difficult to enter, and minute voids remain in the metal-clad laminate.

### (Surface Roughness (Ra))

The prepreg of the present embodiment preferably has a surface roughness (arithmetic average roughness: Ra, which may be hereinafter referred simply to as "Ra") of 0.1 to 5 µm, while not particularly limited.

The surface roughness (Ra) in the present disclosure is the arithmetic average height (Ra) that can be obtained from the roughness curve according to ISO 4287 (1997). JIS B0601 (2001) may be used instead of ISO 4287 (1997). The surface roughness (Ra) in the present disclosure is a surface roughness (Ra) that is obtained by measuring with a shape analysis laser microscope "VK-X100" (manufactured by Keyence Corporation). The roughness curve measured in the present embodiment is a curve obtained by removing a wavelength of more than 80 µm from the cross sectional curve by applying a phase compensation high-pass filter λc (λc = 80 µm) on the cross sectional curve. The analysis region is 1,000 µm × 1,000 µm.

In the prepreg of the present embodiment, by setting Ra to 0.1 µm or more, suitable unevenness is imparted to the surface of the prepreg, whereby the amount of charge of static electricity can be suppressed to a low level, and the handleability tends to be excellent. On the other hand, by setting Ra to 5 µm or less, the thickness accuracy of the metal-clad laminate tends to be improved.

From such a viewpoint, Ra of the prepreg of the present embodiment may be 0.15 to 3 µm, may be 0.2 to 2 µm, may be 0.2 to 1.6 µm, or may be 0.2 to 1.0 µm.

Unless otherwise specified, Ra of the prepreg in the present disclosure is Ra of at least one surface of the prepreg, and the "surface" refers to a surface to be overlapped or a surface opposite thereto when a plurality of prepregs are laminated to prepare a metal-clad laminate. It is preferable that Ra of at least one surface of the prepreg is in the aforementioned range, and it is more preferable that Ra of both surfaces of the prepreg each are in the aforementioned range.

### <Fiber Substrate>

The fiber substrate having a thickness of 40 µm or more contained in the prepreg used in the present embodiment may be a known one used in various laminates for an electric insulating material. Examples of the material of the fiber substrate include natural fibers, such as paper and cotton linters; inorganic fibers, such as glass fibers and asbestos; organic fibers, such as aramid, polyimide, polyvinyl alcohol, polyester, tetrafluoroethylene, and acrylic; and mixtures thereof. Among these, inorganic fibers are preferable, and glass fibers are more preferable, from the viewpoint of the flame retardancy. Further, examples of the glass fibers include glass cloths using E glass, C glass, D glass, S glass, or the like; glass cloths obtained by bonding short fibers with an organic binder; and those obtained by mixing glass fibers and cellulose fibers. Among these, a glass cloth using E glass is preferable as the glass fibers.

The shape of the fiber substrate is not particularly limited, and may be a woven fabric, a nonwoven fabric, a roving, a chopped strand mat, a surfacing mat, or the like. Among these, the use of a woven fabric provides a tendency that the effects of the present embodiment can be more conspicuous. The material and the shape thereof may be appropriately selected depending on the purpose and the capabilities of the target molded article. One kind of the fiber substrate may be used alone, or two or more kinds of materials and two or more kinds of shapes may be used in combination depending on necessity.

The fiber substrate may be a fiber substrate formed of one layer, or may be a fiber substrate including multiple layers. The fiber substrate formed of one layer means a fiber substrate that is formed only of entangled fibers, and the case where a fiber substrate having no entanglement exists is classified into the fiber substrate including multiple layers. The materials and the shapes of the two or more layers of the fiber substrate each may be the same as or different from each other.

### (Thickness of Fiber Substrate)

The thickness of the fiber substrate contained in the prepreg of the present embodiment (see Fig. 4) is set to "40 µm or more", which has been found that the thickness accuracy of the metal-clad laminate tends to deteriorate in the ordinary method. The thickness of the fiber substrate may be 40 to 120 µm, may be 45 to 120 µm, may be 50 to 120 µm, may be 55 to 120 µm, may be 60 to 120 µm, may be 70 to 120 µm, may be 70 to 100 µm, or may be 80 to 100 µm. The thickness of the fiber substrate is preferably less than 100 µm, may be 40 µm or more and less than 100 µm, may be 40 to 97 µm, may be 50 to 97 µm, may be 60 to 97 µm, may be 70 to 97 µm, or may be 80 to 95 µm, from the viewpoint that the impregnation properties of the thermosetting resin composition into the fiber substrate are improved and the heat resistance and insulation reliability of the cured product of the prepreg tend to be more favorable. The fiber substrate tends to have a larger surface waviness by itself when the thickness of the fiber substrate is larger, and therefore the thickness accuracy of the metal-clad laminate is deteriorated by the ordinary method. However, in the prepreg of the present embodiment, even if the thickness of the fiber substrate is large as described above, the surface waviness (Wa) of the prepreg is suppressed to be small, and as a result, the thickness accuracy of the metal-clad laminate is increased.

In the description herein, the thickness of the fiber substrate is the thickness of the portion shown in Fig. 4, and is an average value of values obtained by measuring arbitrary five portions of the fiber substrate with a micrometer.

### (Surface Waviness (Wa) of Fiber Substrate)

The surface waviness (Wa) of the fiber substrate contained in the prepreg of the present embodiment is not particularly limited, may be more than 5.0 µm, may be 6.0 µm or more, may be 7.0 µm or more, may be 10.0 µm or more, or may be 15.0 µm or more. The upper limit value of the surface waviness (Wa) of the fiber substrate of the present embodiment is not particularly limited, may be 40 µm or less, may be 30 µm or less, or may be 25 µm or less. That is, the surface waviness (Wa) of the fiber substrate may be more than 5.0 to 40 µm, may be 6.0 to 30 µm, may be 7.0 to 30 µm, may be 10 to 25 µm, or may be 15 to 25 µm.

According to the present embodiment, even though the surface waviness (Wa) of the fiber substrate is in the aforementioned range, the surface waviness (Wa) of the prepreg can be suppressed to the aforementioned range, and the high thickness accuracy of the metal-clad laminate can be retained.

### <Thermosetting Resin Composition>

As described above, the prepreg of the present embodiment is a prepreg containing a fiber substrate having a thickness of 40 µm or more and a thermosetting resin composition. The thermosetting resin composition contains at least a thermosetting resin. The components contained in the thermosetting resin composition are not particularly limited, and preferably include, in addition to the thermosetting resin, at least one selected from the group consisting of a curing agent, a curing accelerator, an inorganic filler, an organic filler, a coupling agent, a leveling agent, an antioxidant, a flame retardant, a flame retardant aid, a thixotropy imparting agent, a thickener, a flexible material, a surfactant, and a photopolymerization initiator.

Hereinafter, each component contained in the thermosetting resin composition will be described in order.

### (Thermosetting Resin)

Examples of the thermosetting resin include an epoxy resin, a polyimide resin, a maleimide resin, a modified maleimide resin, a phenol resin, a polyphenylene ether resin, a bismaleimide-triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Examples of the modified maleimide resin include a reaction product of a maleimide compound having at least two N-substituted maleimide groups and at least one kind of a compound selected from the group consisting of a monoamine compound and a diamine compound. Here, the maleimide resin does not include the modified maleimide resin. The thermosetting resin is not particularly limited to these resins, and known thermosetting resins may be used. One kind of the thermosetting resin may be used alone, or two or more kinds thereof may be used in combination.

Among these, from the viewpoint of moldability and electrical insulating properties, the thermosetting resin preferably contains at least one selected from the group consisting of an epoxy resin, a polyimide resin, a maleimide resin, a modified maleimide resin, a cyanate resin, a polyphenylene ether resin, and a bismaleimide-triazine resin, and more preferably contains at least one selected from the group consisting of an epoxy resin, a maleimide resin, a modified maleimide resin, and a cyanate resin.

The epoxy resin is preferably an epoxy resin having two or more epoxy groups in one molecule. The epoxy resin herein is classified into a glycidyl ether type epoxy resin, a glycidyl amine type epoxy resin, a glycidyl ester type epoxy resin, and the like. Among these, a glycidyl ether type epoxy resin is preferable.

The epoxy resin is classified into various epoxy resins depending on the difference in main skeleton. For example, the aforementioned types of epoxy resins each are further classified into a bisphenol type epoxy resin, an alicyclic epoxy resin, an aliphatic linear epoxy resin, a novolac type epoxy resin, a stilbene type epoxy resin, a naphthalene skeleton-containing epoxy resin, a biphenyl type epoxy resin, a xylylene type epoxy resin, a dihydroanthracene type epoxy resin, and the like. One kind of the epoxy resin may be used alone, or two or more kinds thereof may be used in combination from the viewpoint of the insulation reliability and the heat resistance.

The epoxy resin may be a novolac type epoxy resin or may be a phenol-novolac type epoxy resin.

The content of the thermosetting resin in the thermosetting resin composition is preferably 10 to 200 parts by mass, more preferably 20 to 150 parts by mass, and still more preferably 20 to 80 parts by mass with respect to 100 parts by mass of the total amount of the thermosetting resin composition.

### (Curing Agent)

In a case where the thermosetting resin contains an epoxy resin, examples of the curing agent include a curing agent for an epoxy resin, such as a phenol-based curing agent, a cyanate ester-based curing agent, an acid anhydride-based curing agent, an amine-based curing agent, and an active ester group-containing compound. In a case where the thermosetting resin contains a resin other than an epoxy resin, a known curing agent for that thermosetting resin may be used. One kind of the curing agent may be used alone, or two or more kinds thereof may be used in combination.

Preferred examples of the phenol-based curing agent include a cresol-novolac type phenol resin, a biphenyl-aralkyl type phenol resin, a phenol-novolac type phenol resin, a naphthylene ether type phenol resin, and a triazine skeleton-containing phenol resin, while not particularly limited.

Examples of the cyanate ester-based curing agent include bisphenol A dicyanate and polyphenyl cyanate (oligo(3-methylene-1,5-phenylenecyanate)), while not particularly limited.

Examples of the acid anhydride-based curing agent include phthalic anhydride, tetrahydrophthalic anhydride, trimellitic anhydride, and pyromellitic anhydride, while not particularly limited.

Examples of the amine-based curing agent include an aliphatic amine, such as triethylenetetramine and tetraethylenepentamine, and an aromatic amine, such as 4,4'-diaminodiphenylmethane, while not particularly limited.

A urea resin and the like may also be used as the curing agent.

In a case where the thermosetting resin composition contains the curing agent, the content thereof is preferably 20 to 200 parts by mass, more preferably 20 to 150 parts by mass, and still more preferably 30 to 100 parts by mass with respect to 100 parts by mass of the thermosetting resin.

In a case where the thermosetting resin composition contains the curing agent, the content thereof may also be expressed in terms of functional group equivalent. Specifically, the content of the curing agent preferably satisfies the expression, ((mass of thermosetting resin)/(functional group equivalent)) ≈ ((mass of curing agent)/(functional group equivalent capable of reacting to thermosetting resin)) × constant C. The constant C varies depending on the kind of the functional group of the curing agent, and is preferably 0.8 to 1.2 for the case where the functional group is a phenolic hydroxy group, preferably 0.2 to 0.4 for the case where the functional group is an amino group, and preferably 0.3 to 0.6 for the case where the functional group is an active ester group.

**In** a case where the thermosetting resin contains an epoxy resin, the expression is ((mass of epoxy resin)/(epoxy group equivalent)) ≈ ((mass of curing agent)/(functional group equivalent capable of reacting to epoxy group)) × constant C.

### (Curing Accelerator)

The curing accelerator used may be an ordinary curing accelerator having been used for curing the thermosetting resin. For example, in a case where the thermosetting resin contains an epoxy resin, examples of the curing accelerator include an imidazole compound and a derivative thereof, a phosphorus compound, a tertiary amine compound, and a quaternary ammonium compound. From the viewpoint of accelerating the curing reaction, an imidazole compound and a derivative thereof are preferable.

Specific examples of the imidazole compound and a derivative thereof include an imidazole compound, such as 2-methylimidazole, 2-ethylimidazole, 2-undecylimidazole, 2-phenylimidazole, 1,2-dimethylimidazole, and 2,4-diamino-6-[2'-methylimidazolyl-(1')]ethyl-s-triazine; a salt of the imidazole compound and trimellitic acid, such as 1-cyanoethyl-2-phenylimidazolium trimellitate; a salt of the imidazole compound and isocyanuric acid; and a salt of the imidazole compound and hydrobromic acid. One kind of the imidazole compound and a derivative thereof may be used alone, or two or more kinds thereof may be used in combination.

The curing accelerator may be an imidazole compound and a derivative thereof, or may be an imidazole compound.

In a case where the thermosetting resin composition contains the curing accelerator, the content thereof is preferably 0.1 to 20 parts by mass, and more preferably 0.1 to 10 parts by mass with respect to 100 parts by mass of the thermosetting resin.

### (Inorganic Filler)

An inorganic filler can reduce the thermal expansion coefficient and can improve the coating film strength.

Examples of the inorganic filler include silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride, boron nitride, clay (such as baked clay), a molybdic acid compound such as zinc molybdate, glass short fibers, glass powder, and hollow glass beads. Preferred examples of the glass as the material of glass short fibers, glass powder, and hollow glass beads include E glass, T glass, and D glass. One kind of the inorganic filler may be used alone, or two or more kinds thereof may be used in combination. Among these, from the viewpoint of reducing the thermal expansion coefficient and reducing the relative permittivity and the dielectric loss tangent, silica and alumina are preferable, and from the viewpoint of the heat resistance, aluminum hydroxide is preferable. As the inorganic filler, the combined use of silica and aluminum hydroxide is more preferable.

Examples of the silica include precipitated silica having a high water content produced by the wet method and dry method silica containing substantially no combined water or the like produced by the dry method. Examples of the dry method silica include crushed silica, fumed silica, and fused silica (molten spherical silica), based on the difference in production method.

The inorganic filler may be subjected to a surface treatment with a surface treating agent, such as a silane coupling agent, for improving the moisture resistance, and may be subjected to a hydrophobizing treatment for improving the dispersibility.

In a case where the thermosetting resin composition contains the inorganic filler, the content thereof is preferably 0.1 to 65% by volume with respect to the total amount of the solid content while varying depending on the purpose of the addition thereof. In a case where the content thereof is 0.1% by volume or more with respect to the total amount of the solid content, the coefficient of thermal expansion tends to be reduced. On the other hand, by suppressing the content to 65% by volume or less, there is a tendency that the viscosity in blending the resin component does not become too high, and the deterioration in workability can be easily suppressed from occurring. From the same viewpoint, the content of the inorganic filler is more preferably 10 to 60% by volume, still more preferably 15 to 55% by volume, and particularly preferably 30 to 55% by volume with respect to the total amount of the solid content.

### (Coupling Agent)

By containing the coupling agent, there is an effect of improving the dispersibility of the inorganic filler and the organic filler, and improving the adhesion to the reinforcing substrate and the metal foil. One kind of the coupling agent may be used alone, or two or more kinds thereof may be used in combination.

The coupling agent may be a titanate coupling agent, a silane coupling agent, or the like.

### (Organic Solvent)

From the viewpoint of facilitating the handling, the thermosetting resin composition may further contain an organic solvent. In the description herein, the thermosetting resin composition that contains an organic solvent may be referred to as a resin varnish.

Examples of the organic solvent include an alcohol-based solvent, such as methanol, ethanol, methyl cellosolve, butyl cellosolve, and propylene glycol monomethyl ether; a ketonebased solvent, such as acetone, methyl ethyl ketone, methyl isobutyl ketone, butanone, cyclohexanone, and 4-methyl-2-pentanone; an ester-based solvent, such as ethyl acetate, butyl acetate, propylene glycol monomethyl ether acetate, and γ-butyrolactone; an ether-based solvent, such as tetrahydrofuran; an aromatic-based solvent, such as toluene, xylene, and mesitylene; a nitrogen atom-containing solvent, such as N,N-dimethylformamide, N,N-dimethylacetamide, and N-methylpyrrolidone; and a sulfur atom-containing solvent, such as dimethylsulfoxide, while not particularly limited.

One kind of the organic solvent may be used alone, or two or more kinds thereof may be used in combination.

From the viewpoint of ease of application, for example, the content of the organic solvent may be adjusted so that the non-volatile content concentration of the thermosetting resin composition is preferably 20 to 85% by mass, and more preferably 40 to 80% by mass.

The resin varnish may be prepared using an organic solvent. However, in the method for producing a prepreg of the present embodiment described later, since a resin film is produced and then the resin film is impregnated into a fiber substrate to obtain a prepreg, the organic solvent is volatilized at the stage of producing the resin film. As a result, the prepreg of the present embodiment contains substantially no organic solvent remaining, and specifically the content thereof may be 5% by mass or less.

The method of preparing the thermosetting resin composition is not particularly limited, and an ordinarily known preparing method may be used.

For example, a resin varnish can be prepared by adding a thermosetting resin and, if necessary, other components to the organic solvent, followed by mixing and stirring using various mixers. Examples of the mixer include mixers of an ultrasonic dispersion type, a highpressure collision dispersion type, a high-speed rotation dispersion type, a bead mill type, a high-speed shear dispersion type, and a planetary centrifugal dispersion type.

### (Thickness of Prepreg)

The thickness of the prepreg of the present embodiment can be appropriately determined depending on the thickness of the fiber substrate and the like, may be 50 to 300 µm, may be 50 to 250 µm, may be 55 to 200 µm, may be 60 to 180 µm, may be 60 to 170 µm, or may be 60 to 150 µm. The thickness of the prepreg herein means the thickness of one ply of the prepreg. In a case where the thickness of the prepreg is the lower limit value or more, there is a tendency that the effect of reducing the surface waviness by the present embodiment is enhanced. In a case where the thickness of the prepreg is the upper limit value or less, there is a tendency that voids can be suppressed from occurring after the production of the laminate in the present embodiment.

In the description herein, the thickness of the prepreg is an average value of values obtained by measuring arbitrary five portions of the prepreg with a digimatic indicator.

### [Method for Producing Prepreg]

The method for producing the prepreg of the present embodiment is not particularly limited, and is preferably the following production method from the viewpoint of enhancing the thickness accuracy.

That is, a method for producing a prepreg having a surface waviness (Wa) of 5.0 µm or less by impregnating a fiber substrate having a thickness of 40 µm or more with a film of a thermosetting resin composition through lamination, the method including providing in the fiber substrate an impregnated region and a non-impregnated region with the thermosetting resin composition, and allowing the non-impregnated region to intermittently exist, is preferable. It is more preferable that the non-impregnated region exists intermittently in the in-plane direction.

In the production method, a film of a thermosetting resin composition (which may be hereinafter referred to as a "resin film") is used. A method of immersing a fiber substrate in a resin varnish, followed by drying, is difficult to provide the non-impregnated region intentionally in the fiber substrate, resulting in a tendency that the surface waviness (Wa) is also increased (see Fig. 3), and therefore the aforementioned production method is preferable.

In the method for producing a prepreg described above, the fiber substrate, the thermosetting resin composition, and the surface waviness (Wa) are explained as described above.

The resin film can be produced by forming a layer of the thermosetting resin composition (resin layer) on one surface of a release film. The resin layer can be formed, for example, by coating the resin varnish on one surface of a release film and then drying.

The method of coating the resin varnish is not particularly limited, and can be performed, for example, by using a known coating device, such as a comma coater, a bar coater, a kiss coater, a roll coater, a gravure coater, and a die coater. The coating device is preferably selected appropriately in consideration of the thickness of the resin layer.

The drying temperature and the drying time may vary depending on the amount of the organic solvent used and the boiling point of the organic solvent, and for example, in the case of the resin varnish containing 30 to 70% by mass of the organic solvent, the resin film can be favorably formed by drying at 50 to 160°C for 1 to 8 minutes.

The film formed in this manner may be referred to as a resin film with a release film.

### (Thickness of Resin Film)

The thickness of the resin film may be appropriately determined depending on the thickness of the prepreg and the like. For example, in a case where the thickness of the fiber substrate is in a range of 40 to 120 µm, the thickness of the resin film is preferably 10 to 100 µm, more preferably 15 to 70 µm, and still more preferably 20 to 50 µm. In the description herein, the thickness of the resin film is a value that is measured in the following manner. First, the total thickness of the film with the resin after coating is measured at arbitrary five portions with a digimatic indicator. At each of the measured portions, after removing the resin layer with an adhesive tape, the thickness of the release film is measured with a digimatic indicator, and the values obtained by subtracting the thickness of the release film from the total thickness are averaged.

In a case where the thickness of the resin film is the lower limit value or more, there is a tendency that the amount of the resin for impregnating a thick glass cloth having a thickness of 40 µm or more can be sufficiently secured. In a case where the thickness of the resin film is the upper limit value or less, there is a tendency that the resin film can be easily produced.

### (Release Film)

Examples of the release film include an organic film, such as polyethylene terephthalate (PET), biaxially stretched polypropylene (OPP), polyethylene, polyvinyl fluoride, and polyimide; and a metal or alloy film, such as copper and aluminum. The release film may be subjected to a release treatment with a release agent.

The thickness of the release film is not particularly limited, and is preferably 10 to 200 µm, more preferably 20 to 100 µm, and still more preferably 30 to 70 µm, from the viewpoint of the handleability in coating the thermosetting resin composition and the economic efficiency.

A commercially available product may also be used as the release film.

### (Method of Impregnating Fiber Substrate with Resin Film)

Next, a method of impregnating the fiber substrate with the resin film through lamination will be described.

First, the resin film with the release film is disposed on at least one surface of the fiber substrate in such a manner that the resin film is brought into contact with the fiber substrate. Thereafter, the resin film with the release film thus disposed and the fiber substrate are heated and pressurized, and thereby the fiber substrate is impregnated with the resin film. At this time, the non-impregnated region with the thermosetting resin composition is intermittently provided in the fiber substrate. The prepreg of the present embodiment with the release film is thus obtained in this manner.

The heating and pressurizing herein is preferably performed through lamination. Examples of the method of the lamination include (a) roll lamination and (b) a lamination method under reduced pressure, such as a vacuum lamination method.

While the condition of the roll lamination (a) is not particularly limited, the heating temperature is preferably 80 to 180°C, and the pressurizing pressure (linear pressure) is preferably 0.05 to 1.0 MPa/m.

While the condition of the lamination method under reduced pressure (b) is not particularly limited, the heating temperature is preferably 50 to 170°C, and more preferably 110 to 160°C, the pressurizing time is preferably 10 to 120 seconds, and more preferably 20 to 80 seconds, and the pressurizing pressure is preferably 0.05 to 1.0 MPa, and more preferably 0.1 to 0.6 MPa.

### (Method of Intermittently Providing Non-impregnated Region)

Examples of the method of intermittently providing the non-impregnated region with the thermosetting resin composition in the fiber substrate include a method of regulating the condition in heating and pressurizing the resin film with the release film and the fiber substrate, while not particularly limited. Specific examples thereof include a method of regulating the lamination condition.

Here, in a case where the same lamination condition is applied to the case of a thin fiber substrate and the case of a thick fiber substrate, the case of a thick fiber substrate has a tendency that the fiber substrate is more difficult to impregnate with the resin film. Therefore, even in the case where the lamination condition in the present embodiment is equivalent to the condition in laminating the resin film with the ordinary thin fiber substrate, the non-impregnated region with the thermosetting resin composition can be intermittently provided in the fiber substrate in the present embodiment.

Specific examples of the method of regulating the condition in heating and pressurizing include the following method, while not particularly limited. First, a prepreg is produced under the prescribed heating and pressurizing condition, and thereafter the existing ratio of the impregnated region with the thermosetting resin composition in the fiber substrate is obtained based on the calculation method described above. As a result, in a case where the impregnated region is 100%, i.e., there is no non-impregnated region, a prepreg is again produced by decreasing the heating temperature or decreasing the pressurizing pressure, or by decreasing both the heating temperature and the pressurizing pressure, and the existing ratio of the impregnated region is obtained again. By further repeating this as necessary, it is possible to easily grasp the conditions for producing the prepreg having the non-impregnated region intermittently (preferably intermittently in the in-plane direction).

In a case where the existing ratio of the non-impregnated region is to be regulated lower, a prepreg is again produced by increasing the heating temperature or increasing the pressurizing pressure, or by increasing both the heating temperature and the pressurizing pressure.

The heating temperature is preferably 120°C or higher, more preferably 120 to 170°C, and still more preferably 130 to 160°C from the viewpoint of intermittently providing the non-impregnated region with the thermosetting resin composition in the fiber substrate.

The pressurizing pressure is preferably 0.2 MPa or more, more preferably 0.2 to 1.0 MPa, still more preferably 0.3 to 0.8 MPa, and particularly preferably 0.3 to 0.6 MPa from the viewpoint of intermittently providing the non-impregnated region with the thermosetting resin composition in the fiber substrate.

In a case where the lamination is performed under reduced pressure, the existing ratio of the non-impregnated region can also be regulated by regulating the vacuum degree.

It is preferred that one or more plies of the resin film is disposed and laminated on each of both surfaces of the fiber substrate. The number of plies of the resin film is preferably one or two, and more preferably one, per one surface of the fiber substrate.

After impregnating the fiber substrate with the resin film, the resulting product is cooled depending on necessity, and then the release film is released therefrom to produce the prepreg having a surface waviness (Wa) of 5.0 µm or less.

### [Laminate and Metal-Clad Laminate]

The present disclosure also provides a laminate including one or more plies of the prepreg of the present embodiment. The laminate that has a metal foil disposed therein is referred particularly to as a "metal-clad laminate". That is, the present disclosure also provides a metal-clad laminate including a metal foil and one or more plies of the prepreg of the present embodiment. The prepreg of the present embodiment may be used in combination with another prepreg. In the laminate and the metal-clad laminate of the present embodiment, the number of plies of the prepreg may be 1 to 20, may be 2 to 20, may be 5 to 18, or may be 8 to 16, as long as one or more plies of the prepreg of the present embodiment are included.

Examples of the metal foil included in the metal-clad laminate include a copper foil, an aluminum foil, a tin foil, a tin-lead alloy (solder) foil, and a nickel foil. The thickness of the metal foil may be a thickness that is ordinarily used in laminates, and is, for example, 1 to 200 µm. In addition, it is possible to use a composite foil having a three layer structure in which nickel, nickel-phosphorus, a nickel-tin alloy, a nickel-iron alloy, lead, a lead-tin alloy, or the like is used as an intermediate layer and a copper layer having a thickness of 0.5 to 15 µm and a copper layer having a thickness of 10 to 300 µm are provided on both surfaces of the intermediate layer, a composite foil having a two layer structure in which aluminum and a copper foil are composited, and the like.

In a case where the metal foil is a copper foil, the metal-clad laminate is referred to as a copper-clad laminate.

The laminate and the metal-clad laminate of the present embodiment can be produced using a plurality of plies of the prepreg, and may include three or more plies of the fiber substrate. Since the laminate and the metal-clad laminate of the present embodiment have high thickness accuracy, it is not necessary to perform a smoothing treatment such as polishing and roll pressing on the surface of the cured product of the prepreg included in the laminate and the metal-clad laminate of the present embodiment, and thus the productivity is excellent. Therefore, in the metal-clad laminate including three or more plies of the fiber substrate, the fiber substrate located on the outermost side is not shaved by the smoothing treatment, and the thickness of the fiber substrate located on the outermost side on at least one surface side of the laminate or the metal-clad laminate is in a range of 0.6 to 1.3 times, preferably in a range of 0.7 to 1.3 times, more preferably in a range of 0.8 to 1.2 times, and still more preferably in a range of 0.9 to 1.1 times the thickness of the fiber substrate adjacent to the fiber substrate. It is preferable that the thickness of the fiber substrate located on the outermost side on both surface sides of the laminate or the metal-clad laminate is within the above range with respect to the thickness of the adjacent fiber substrate.

### [Method for Producing Metal-Clad Laminate]

The present disclosure also provides a method for producing a metal-clad laminate, including disposing metal foils on both surfaces of one ply of the prepreg of the present embodiment, or on both surfaces of a prepreg laminate including at least one or more plies of the prepreg of the present embodiment, and then press-molding. Specific examples of the method of press-molding include a method of press-molding under conditions of a vacuum degree of preferably 300 kPa or less, and more preferably 100 kPa or less, a temperature of preferably 130 to 350°C, more preferably 150 to 300°C, and still more preferably 170 to 250°C, and a pressure of preferably 0.5 to 10 MPa, more preferably 1 to 5 MPa, and still more preferably 2 to 5 MPa, with a vacuum press. The press molding allows the thermosetting resin composition to flow into the non-impregnated region with the thermosetting resin composition in the fiber substrate, and as a result, voids can be suppressed from occurring.

It is preferred that 10% by mass or more of the prepreg laminate is constituted by the prepreg of the present embodiment, it is more preferred that 20% by mass or more thereof is constituted by the prepreg of the present embodiment, it is still more preferred that 50% by mass or more thereof is constituted by the prepreg of the present embodiment, and the entire thereof may be constituted by the prepreg of the present embodiment, from the standpoint of achieving the metal-clad laminate having high thickness accuracy, while not particularly limited. However, even in the case where less than 10% by mass of the prepreg laminate is constituted by the prepreg of the present embodiment, the prepreg contributes to the enhancement of the thickness accuracy of the metal-clad laminate.

The laminate of the present embodiment can be obtained by removing the metal foil from the metal-clad laminate of the present embodiment by an etching treatment or the like.

### [Printed Wiring Board]

The present disclosure also provides a printed wiring board including the laminate of the present embodiment or the metal-clad laminate of the present embodiment. In other words, the present disclosure also provides a printed wiring board obtained by forming a wiring pattern on the laminate of the present embodiment or the metal-clad laminate of the present embodiment.

The printed wiring board of the present embodiment can be produced by forming a wiring pattern on the laminate of the present embodiment or the metal-clad laminate of the present embodiment. Examples of the method of forming a wiring pattern include known processes, such as a subtractive process, a full additive process, a semi-additive process (SAP), and a modified semi-additive process (m-SAP).

### [Semiconductor Package]

The present disclosure also provides a semiconductor package including the printed wiring board of the present embodiment and a semiconductor element. The semiconductor package of the present embodiment can be produced, for example, by mounting a semiconductor element such as a semiconductor chip or a memory at a predetermined position of the printed wiring board of the present embodiment by a known method, and then sealing the semiconductor element with a sealing resin or the like.

### Examples

The present embodiment will be described in more detail with reference to examples below, but the examples do not limit the present embodiment.

The prepregs and the copper-clad laminates produced in the examples were evaluated in the following manner.

### [1. Surface Waviness (Wa)]

The prepreg produced in each of the examples was measured for the surface waviness (Wa). The shape measurement was automatically performed with the observation application using a shape analysis laser microscope "VK-X100" (manufactured by Keyence Corporation) to obtain a waviness curve in accordance with ISO 4287 (1997). The resulting waviness curve was analyzed for the surface roughness with the analysis application thereof to calculate the surface waviness (Wa). The waviness curve herein is a curve obtained by removing the component having a wavelength of less than 80 µm from the cross sectional curve by applying a phase compensation high-pass filter λc (λc = 80 µm) on the cross sectional curve. The analysis region was 1,000 µm × 1,000 µm.

The surface waviness (Wa) was measured for both surfaces of the prepreg, and the larger value was used.

### [2. Existing Ratio of Impregnated Region]

The existing ratio (%) of the impregnated region with the thermosetting resin composition in the fiber substrate was obtained based on the following calculation method.

### - Calculation Method -

The surface of the prepreg was observed with an optical microscope (MX61L-F, trade name, manufactured by Olympus Corporation) under the following condition to provide a surface observation image.

### <Observation Condition>

- Magnification: 50 times
- Observation mode: dark field
- Sensibility: ISO400
- Exposure time in surface imaging: 60 to 100 ms
- Brightness of observation environment: two 35 W fluorescent light tubes disposed 2 m above observation stage

The resulting surface observation image was converted to monochrome mode with image editing software, and saved in BMP (Microsoft Windows Bitmap Image) format. Subsequently, the surface observation image in monochrome mode saved in BMP format was converted to RGB (red, green, blue) values pixel by pixel with image converting software, and then saved in CSV (comma-separated values) format. The RGB data saved in CSV format was pasted on Microsoft Excel (available from Microsoft Corporation), and calculated for the areas of the black part (RGB value = 255) and the white part (RGB value = 0). The area ratio of the black part with respect to the total of the black part and the white part was calculated from the resulting values. The area ratio of the black part thus obtained was designated as the existing ratio (%) of the impregnated region.

The surface observation image was imaged in such a manner that the impregnated region and the non-impregnated region were sufficiently reflected, with suitable brightness by regulating the exposure time in surface imaging within 60 to 100 ms as described above.

The image editing software used was Microsoft Paint (available from Microsoft Corporation). The image converting software used was "bmp2csv" which is free software.

### [3. Presence or Absence of Intersection of Thermosetting Resin Compositions on Front and Back]

As shown in Table 1, the presence or absence of color intersection when a prepreg was prepared by laminating resin films having different colors on the front and back of a glass cloth was visually observed. For example, in a case where the prepreg was observed from the front side, in a case where there was no change from the color of the resin film used on the front side, the intersection was evaluated as "not present", and in a case where there was a change to a color in which the color of the resin film used on the front side and the color of the resin film used on the back side were mixed, the intersection was evaluated as "present". In the case of "present", it is determined that the non-impregnated region exists intermittently, and in the case of "not present", it is determined that the non-impregnated region does not exist intermittently.

### [4. Thickness Variation of Copper-Clad Laminate]

The copper-clad laminate obtained in each of the examples was measured for the thickness at 10 positions from the center in the width direction of the laminate every 50 mm in the width direction, and 10 positions from each of the 10 positions as starting points in the length direction every 50 mm (which were 10 positions including the starting points, i.e., the number of measured positions was 10 × 10 = 100 positions). Specifically, the thickness was measured to the unit of 0.001 mm with a horizontal pedestal and a digimatic indicator "ID-C112P" (manufactured by Mitutoyo Corporation). The value obtained by the following expression was designated as the index of thickness variation. A smaller value thereof means a smaller thickness variation, and thus shows excellent thickness accuracy. Thickness variation (%) = 100 × (((maximum value of thickness)-(average value of thickness))/(average value of thickness))

### [5. Insulation Reliability]

The copper-clad laminate obtained in each of the examples was drilled to form through holes such that the through hole interval (distance between adjacent hole walls) was 200 µm, and then the formed through holes were subjected to a desmear treatment, then an electroless plating treatment was performed, and then an electroplating treatment was performed, thereby preparing a test pattern in which the upper and lower sides of the copper-clad laminate were electrically connected, and this was used as a measurement sample. The insulation resistance of the 160 holes of each measurement sample was measured with time. The measurement was performed by applying 5.5 V in an atmosphere of 130°C and 85% RH, and the time until conduction breakdown occurred was measured. The measurement time was set to be up to 200 hours, and it was determined that the insulation reliability was sufficient when the measurement time was more than 200 hours.

### Reference Example 1

The following glass cloths were measured for the surface waviness (Wa) in the same manner as in [1. Surface Waviness (Wa)] above, and thereafter the glass cloths having various thicknesses were compared for the surface waviness (Wa). The thickness of each glass cloth below is the average value of values obtained by measuring arbitrary five portions with a micrometer "MDC-25MX" (manufactured by Mitutoyo Corporation).
<Glass Cloth Having Thickness of 40 µm or More>
   (i) Glass cloth "IPC #2116" (manufactured by Nitto Boseki Co., Ltd., basis weight: 104 g/m², substrate width: 530 mm, thickness: 91 µm)
   (ii) Glass cloth "IPC #3313" (manufactured by Nitto Boseki Co., Ltd., basis weight: 82 g/m², substrate width: 530 mm, thickness: 73 µm)
   (iii) Glass cloth "IPC #1078" (manufactured by Nitto Boseki Co., Ltd., basis weight: 47 g/m², substrate width: 530 mm, thickness: 44 µm)
<Glass Cloth Having Thickness of Less Than 40 µm>
   (iv) Glass cloth "IPC #1037" (manufactured by Nitto Boseki Co., Ltd., basis weight: 24 g/m², substrate width: 530 mm, thickness: 24 µm)
   (v) Glass cloth "IPC #1027" (manufactured by Nitto Boseki Co., Ltd., basis weight: 20 g/m², substrate width: 530 mm, thickness: 21 µm)

The glass cloths "IPC #2116", "IPC #3313", and "IPC #1078" had surface wavinesses (Wa) of 21.9 µm, 13.4 µm, and 7.3 µm, respectively.

The glass cloths "IPC #1037" and "IPC #1027" had surface wavinesses (Wa) of 4.7 µm and 4.5 µm, respectively.

It is understood that a glass cloth having a thickness of 40 µm or more has a larger surface waviness (Wa) than a glass cloth having a thickness of less than 40 µm.

### Production Example 1

### (1-1. Production of Resin Varnish A)

60 parts by mass of a phenol-novolac type epoxy resin "EPICLON (registered trademark) N-770" (manufactured by DIC Corporation, epoxy equivalent: 188 g/eq), 40 parts by mass of a biphenyl-aralkyl type phenol resin (manufactured by UBE Corporation, trade name: MEH-7700), 17.5 parts by mass of aluminum hydroxide, 86 parts by mass of fused silica, 0.5 parts by mass of 2-methylimidazole, and methyl isobutyl ketone and cyclohexanone as diluent solvents were added and mixed to produce a resin varnish A having a white color and a solid concentration of 65% by mass (content of aluminum hydroxide: 8% by volume, content of fused silica: 32% by volume).

### (1-2. Production of Resin Varnish B)

Sudan black (trade name: SUDAN BLACK 141, manufactured by Chuo Synthetic Chemical Co., Ltd.) was further added to the resin varnish A in an amount of 0.3% by mass with respect to the total solid content, and the mixture was stirred to produce a resin varnish B having a black color and a solid concentration of 65% by mass (content of aluminum hydroxide: 8% by volume, content of fused silica: 32% by volume). The resin varnish B is obtained by merely adding a black color to the resin varnish A.

### Production Example 2

### (1. Production of Modified Maleimide Resin)

In a reaction vessel having a capacity of 2 L capable of being heated and cooled equipped with a thermometer, a stirring device, and a water quantitative meter having a reflux condenser, 595.8 g of bis(4-maleimidophenyl)methane, 54.2 g of 4,4'-diaminodiphenylmethane, and 350.0 g of propylene glycol monomethyl ether were placed and then reacted for 5 hours under refluxing, so as to provide a solution of a modified maleimide resin.

### (2-1. Production of Resin Varnish C)

107 parts by mass of the solution of a modified maleimide resin above, 30 parts by mass of a tetrafunctional naphthalene type epoxy resin "EXA-4710" (manufactured by DIC Corporation), 17.5 parts by mass of aluminum hydroxide, 130 parts by mass of fused silica, 0.5 parts by mass of 2,4-diamino-6-[2'-undecylimidazolyl-(1')]-ethyl-s-triazine, and methyl isobutyl ketone and cyclohexanone as diluent solvents were added and mixed to produce a resin varnish C having a brown color and a solid concentration of 65% by mass (content of aluminum hydroxide: 8% by volume, content of fused silica: 41.5% by volume).

### (2-2. Production of Resin Varnish D)

Sudan black (trade name: SUDAN BLACK 141, manufactured by Chuo Synthetic Chemical Co., Ltd.) was further added to the resin varnish C in an amount of 0.3% by mass with respect to the total solid content, and the mixture was stirred to produce a resin varnish D having a black color and a solid concentration of 65% by mass (content of aluminum hydroxide: 8% by volume, content of fused silica: 41.5% by volume). The resin varnish D is obtained by merely adding a black color to the resin varnish C.

### Example 1

### (1. Production of Resin Film)

The resin varnish A obtained in Production Example 1 was coated on a PET film (manufactured by Toyobo Film Solutions, Ltd., thickness: 50 µm, a release film, trade name: G2) with a comma coater. At this time, the coating amount was regulated to make a coating width of 530 mm and a thickness after drying of 30 µm. Thereafter, the resultant was heated and dried at 130°C for 2 minutes to produce a resin film A with a PET film.

In addition, in the same manner as described above, a resin film B with a PET film was produced using the resin varnish B obtained in Production Example 1.

### (2. Production of Prepreg)

Next, the resin film A with a PET film was disposed on the front surface of a glass cloth "IPC #2116" (manufactured by Nitto Boseki Co., Ltd., basis weight: 104 g/m², substrate width: 530 mm, thickness: 91 µ m) so that the resin layer surface of the resin film A with a PET film was in contact with the glass cloth, and the resin film B with a PET film was disposed on the back surface of the glass cloth "IPC #2116" so that the resin layer surface of the resin film B with a PET film was in contact with the glass cloth.

This laminate of "PET film/resin film A/glass cloth/resin film B/PET film" was heated and pressurized under vacuum using a vacuum laminating apparatus. According to the procedure, a prepreg with a PET film having the glass cloth impregnated with the thermosetting resin composition of the resin film was obtained. The condition of vacuum lamination was a heating platen temperature of 130°C, a crimping pressure of 0.5 MPa, a vacuum degree of 100 kPa or less, and a vacuum time of 30 seconds. The PET film was released from the resulting prepreg with a PET film, so as to obtain a prepreg 1 having a thickness of 125 µm.

The thickness of the prepreg 1 was the average value of values obtained by measuring arbitrary five portions with a horizontal pedestal and a digimatic indicator (manufactured by Mitutoyo Corporation).

The content ratio of the thermosetting resin composition in the prepreg 1 was calculated in the following manner. The mass (wᵣ) of the resin film was calculated by subtracting the total mass of the two plies of the PET films from the total mass of two plies of the resin films with a PET film used in producing the prepreg 1. The content ratio of the thermosetting resin composition was obtained using the mass (wᵣ) of the resin film and the mass (wₚ) of the prepreg 1 according to the following equation.

Content ratio of thermosetting resin composition = (wᵣ/wₚ) × 100

The resulting prepreg 1 was evaluated as described above. The results are shown in Table 1. Further, the surface observation image of the prepreg converted to monochrome mode used in calculating the existing ratio of the impregnated region is shown in Fig. 5. The observation condition of the surface of the prepreg was as described above, and the exposure time in imaging the surface was 85 ms.

### (3. Production of Copper-Clad Laminate)

12 plies of the resulting prepreg 1 were laminated, and copper foils having a thickness of 12 µm "GTS-12" (manufactured by Furukawa Electric Co., Ltd.) were disposed on the upper and lower surfaces of the laminate. Subsequently, the assembly was pressed under the following condition, so as to produce a copper-clad laminate 1. The resulting copper-clad laminate 1 was evaluated as described above. The results are shown in Table 1.

### - Press Condition -

Heating conditions: the temperature was raised from 25°C to 185°C at a temperature raising rate of 3°C/min, held at 185°C for 90 minutes, and then cooled for 30 minutes.

Pressure condition (pressure applied to 12 plies of prepreg sandwiched between copper foils): 4 MPa (from the start of temperature raising to the end of cooling)

### Example 2

A prepreg 2 (thickness of 125 µm) was produced by performing the same procedure as in Example 1 except that the resin varnish C produced in Production Example 2 was used instead of the resin varnish A and the resin varnish D produced in Production Example 2 was used instead of the resin varnish B in the production of the prepreg of Example 1. A copper-clad laminate 2 was produced by performing the same procedure as in Example 1 except that in the production of the copper-clad laminate in Example 1, the prepreg 2 was used instead of the prepreg 1, and the press condition was changed as shown below. The evaluation results are shown in Table 1.

### - Press Condition -

Heating conditions: the temperature was raised from 25°C to 230°C at a temperature raising rate of 3°C/min, held at 230°C for 90 minutes, and then cooled for 30 minutes.

Pressure condition (pressure applied to 12 plies of prepreg sandwiched between copper foils): 4 MPa (from the start of temperature raising to the end of cooling)

### Example 3

A prepreg 3 (thickness: 115 µm) was produced by performing the same procedure as in Example 1 except that the heating platen temperature of vacuum lamination was changed to 150°C in the production of the prepreg in Example 1. A copper-clad laminate 3 was produced by performing the same procedure as in Example 1 except that in the production of the copper-clad laminate in Example 1, the prepreg 3 was used instead of the prepreg 1. The evaluation results are shown in Table 1.

### Example 4

A prepreg 4 (thickness: 110 µm) was produced by performing the same procedure as in Example 1 except that the heating platen temperature of vacuum lamination was changed to 150°C and the vacuum time was changed to 60 seconds in the production of the prepreg in Example 1. A copper-clad laminate 4 was produced by performing the same procedure as in Example 1 except that in the production of the copper-clad laminate in Example 1, the prepreg 4 was used instead of the prepreg 1. The evaluation results are shown in Table 1.

### Example 5

A prepreg 5 (thickness: 125 µm) was produced by performing the same procedure as in Example 2 except that in the production of the resin film in Example 2, the PET film was changed to a PET film (manufactured by Toray Industries, Inc., thickness: 50 µm, a release film, trade name: Lumirror (registered trademark) #50-X44), and in the production of the prepreg therein, the condition of the vacuum lamination was changed to a heating platen temperature of 140°C and a vacuum time of 40 seconds. A copper-clad laminate 5 was produced by performing the same procedure as in Example 2 except that in the production of the copper-clad laminate in Example 2, the prepreg 5 was used instead of the prepreg 2. The evaluation results are shown in Table 1.

### Example 6

A prepreg 6 (thickness: 105 µm) was produced by performing the same procedure as in Example 1 except that in the production of the prepreg in Example 1, the glass cloth "IPC #2116" was changed to a glass cloth "IPC #3313" (manufactured by Nitto Boseki Co., Ltd., basis weight: 82 g/m², substrate width: 530 mm, thickness: 73 µm). A copper-clad laminate 6 was produced by performing the same procedure as in Example 1 except that in the production of the copper-clad laminate in Example 1, the prepreg 6 was used instead of the prepreg 1. The evaluation results are shown in Table 1.

### Example 7

A prepreg 7 (thickness: 70 µm) was produced by performing the same procedure as in Example 1 except that in the production of the resin film in Example 1, the thickness after drying was changed to 24 µm, and in the production of prepreg therein, the glass cloth "IPC #2116" was changed to a glass cloth "IPC #1078" (manufactured by Nitto Boseki Co., Ltd., basis weight: 47 g/m², substrate width: 530 mm, thickness: 44 µm). A copper-clad laminate 7 was produced by performing the same procedure as in Example 1 except that in the production of the copper-clad laminate in Example 1, the prepreg 7 was used instead of the prepreg 1. The evaluation results are shown in Table 1.

### Example 8

A copper-clad laminate 8 was produced by performing the same procedure as in Example 1 except that in the production of the copper-clad laminate in Example 1, "2 plies of the prepreg 1" and "10 plies of the prepreg X produced in Comparative Example 1 described later" were laminated instead of laminating 12 plies of the prepreg 1. The order of lamination of the prepreg was (1 ply of prepreg 1)/(10 plies of prepreg X)/(1 ply of prepreg 1). The evaluation results are shown in Table 1.

### Example 9

A copper-clad laminate 9 was produced by performing the same procedure as in Example 2 except that in the production of the copper-clad laminate in Example 2, "4 plies of the prepreg 2" and "8 plies of the prepreg X produced in Comparative Example 1 described later" were laminated instead of laminating 12 plies of the prepreg 2. The order of lamination of the prepreg was (2 plies of prepreg 2)/(8 plies of prepreg X)/(2 plies of prepreg 2). The evaluation results are shown in Table 1.

### Comparative Example 1

A glass cloth "IPC #2116" (manufactured by Nitto Boseki Co., Ltd., basis weight: 104 g/m², substrate width: 530 mm, thickness: 91 µm) was immersed in the resin varnish A prepared in Production Example 1, then taken out therefrom, and dried by heating to 140°C for 3.5 minutes to obtain a prepreg X (thickness: 180 µm). A copper-clad laminate X was produced by performing the same procedure as in Example 1 except that in the production of the copper-clad laminate in Example 1, the prepreg X was used instead of the prepreg 1. The evaluation results are shown in Table 1.

It is understood that the prepreg X has a larger surface waviness than the prepregs 1 to 9 produced in Examples, and the copper-clad laminate 10 produced by using the prepreg X has a larger thickness variation. The existing ratio of the impregnated region of the prepreg X was unable to determine since the surface of the prepreg was not in focus in observing with the optical microscope due to the large surface waviness.

### Comparative Example 2

A prepreg 11 (thickness: 135 µm) was produced by performing the same procedure as in Example 1 except that the heating platen temperature of vacuum lamination was changed to 120°C and the crimping pressure was changed to 0.1 MPa in the production of the prepreg in Example 1. A copper-clad laminate 11 was produced by performing the same procedure as in Example 1 except that in the production of the copper-clad laminate in Example 1, the prepreg 11 was used instead of the prepreg 1. The evaluation results are shown in Table 1.

### Comparative Example 3

A prepreg 12 (thickness: 75 µm) was produced by performing the same procedure as in Example 7 except that the heating platen temperature of vacuum lamination was changed to 120°C and the crimping pressure was changed to 0.1 MPa in the production of the prepreg in Example 7. A copper-clad laminate 12 was produced by performing the same procedure as in Example 7 except that in the production of the copper-clad laminate in Example 7, the prepreg 12 was used instead of the prepreg 7. The evaluation results are shown in Table 1.

### Comparative Example 4

A prepreg 13 (thickness: 110 µm) was produced by performing the same procedure as in Example 1 except that the heating platen temperature of vacuum lamination was changed to 160°C, the crimping pressure was changed to 1.0 MPa, and the vacuum time was changed to 60 seconds in the production of the prepreg in Example 1. A copper-clad laminate 13 was produced by performing the same procedure as in Example 1 except that in the production of the copper-clad laminate in Example 1, the prepreg 13 was used instead of the prepreg 1. The evaluation results are shown in Table 1.

### [Table 1]

**Table 1**

| | | Examples | | | | |
|---|---|---|---|---|---|---|
| | | 1 | 2 | 3 | 4 | 5 |
| Type of copper-clad laminate | | 1 | 2 | 3 | 4 | 5 |
| Prepreg | Type of prepreg used | 1 | 2 | 3 | 4 | 5 |
| | Type of resin varnish (front) | A | C | A | A | c |
| | Type of resin varnish (back) | B | D | B | B | D |
| | Type of glass cloth | #2116 | #2116 | #2116 | #2116 | #2116 |
| | Thickness (µm) of glass cloth | 91 | 91 | 91 | 91 | 91 |
| | Content ratio (% by mass) of thermosetting resin composition | 45 | 50 | 45 | 45 | 45 |
| | Thickness of prepreg (µm) | 125 | 125 | 115 | 110 | 125 |
| | Number of plies laminated during production of copper-clad laminate | 12 | 12 | 12 | 12 | 12 |
| Evaluation results of prepreg | 1. Surface waviness Wa (µm) | 0.5 | 0.6 | 1.8 | 3.2 | 0.5 |
| | 2. Existing ratio (%) of impregnated region | 58 | 55 | 90 | 94 | 76 |
| | 3. Presence or absence of intersection of thermosetting resin compositions on front and back | Present | Present | Present | Present | Present |
| Evaluation results of copper-clad laminate | 4. Thickness variation (%) of copper-clad laminate | 0.6 | 0.5 | 1.4 | 1.9 | 0.5 |
| | 5. Insulation reliability (hour) | >200 | >200 | >200 | >200 | >200 |

| | | | | | | |
|---|---|---|---|---|---|---|
| *1: Not measurable | | | | | | |

**Table 1 (continued)**

| | | Examples | | | | | |
|---|---|---|---|---|---|---|---|
| | | 6 | 7 | 8 | | 9 | |
| Type of copper-clad laminate | | 6 | 7 | 8 | | 9 | |
| Prepreg | Type of prepreg used | 6 | 7 | 1 | X | 2 | X |
| | Type of resin varnish (front) | A | A | A | A | C | A |
| | Type of resin varnish (back) | B | B | B | | D | |
| | Type of glass cloth | #3313 | #1078 | #2116 | #2116 | #2116 | #2116 |
| | Thickness (µm) of glass cloth | 73 | 44 | 91 | 91 | 91 | 91 |
| | Content ratio (% by mass) of thermosetting resin composition | 50 | 55 | 45 | 45 | 50 | 45 |
| | Thickness of prepreg (µm) | 105 | 70 | 125 | 180 | 125 | 180 |
| | Number of plies laminated during production of copper-clad laminate | 12 | 12 | 2 | 10 | 4 | 8 |
| Evaluation results of prepreg | 1. Surface waviness Wa (µm) | 0.7 | 0.6 | 0.6 | 5.5 | 0.6 | 5.5 |
| | 2. Existing ratio (%) of impregnated region | 68 | 82 | 55 | -*1 | 55 | -*1 |
| | 3. Presence or absence of intersection of thermosetting resin compositions on front and back | Present | Present | Present | | Present | |
| Evaluation results of copper-clad laminate | 4. Thickness variation (%) of copper-clad laminate | 0.6 | 0.6 | 2.5 | | 1.9 | |
| | 5. Insulation reliability (hour) | >200 | >200 | >200 | | >200 | |

| | | | | | | | |
|---|---|---|---|---|---|---|---|
| *1: Not measurable | | | | | | | |

**Table 1 (continued)**

| | | Comparative Example | | | |
|---|---|---|---|---|---|
| | | 1 | 2 | 3 | 4 |
| Type of copper-clad laminate | | 10 | 11 | 12 | 13 |
| Prepreg | Type of prepreg used | X | 11 | 12 | 13 |
| | Type of resin varnish (front) | A | A | A | A |
| | Type of resin varnish (back) | | B | B | B |
| | Type of glass cloth | #2116 | #2116 | #1078 | #2116 |
| | Thickness (µm) of glass cloth | 91 | 91 | 44 | 91 |
| | Content ratio (% by mass) of thermosetting resin composition | 45 | 45 | 55 | 45 |
| | Thickness of prepreg (µm) | 180 | 135 | 75 | 110 |
| | Number of plies laminated during production of copper-clad laminate | 12 | 12 | 12 | 12 |
| Evaluation results of prepreg | 1. Surface waviness Wa (µm) | 5.5 | 1.4 | 1.2 | 5.9 |
| | 2. Existing ratio (%) of impregnated region | -*1 | 20 | 25 | 100 |
| | 3. Presence or absence of intersection of thermosetting resin compositions on front and back | Present | Not present | Not present | Present |
| Evaluation results of copper-clad laminate | 4. Thickness variation (%) of copper-clad laminate | 3.2 | 0.5 | 0.5 | 4.1 |
| | 5. Insulation reliability (hour) | >200 | 65 | 48 | >200 |

| | | | | | |
|---|---|---|---|---|---|
| *1: Not measurable | | | | | |

It is understood from Table 1 that the use of the prepreg of the present embodiment provides high thickness accuracy of the copper-clad laminate irrespective of the use of a fiber substrate having a relatively large waviness, i.e., a fiber substrate having a thickness of 40 µm or more (see Examples 1 to 9). In addition, the copper-clad laminates of Examples 1 to 9 also have excellent insulation reliability.

On the other hand, as shown in Comparative Example 1, in the prepreg produced by the method of immersing the glass cloth in the resin varnish, followed by drying, the surface waviness (Wa) was large, and the thickness variation of the copper-clad laminate was large. In Comparative Example 2 and Comparative Example 3, since the existing ratio of the impregnated region was too small, the existence of the non-impregnated region was not intermittent, and as a result, the insulation reliability was lowered. In Comparative Example 4, the non-impregnated region was not present, and as a result, the thickness accuracy of the copper-clad laminate was lowered.

## Claims

1. A prepreg comprising a fiber substrate having a thickness of 40 µm or more and a thermosetting resin composition, wherein the prepreg has an impregnated region and a non-impregnated region with the thermosetting resin composition in the fiber substrate, the non-impregnated region exists intermittently, and the prepreg has a surface waviness (Wa) of 5.0 µm or less.

2. The prepreg according to claim 1, wherein the non-impregnated region exists intermittently in an in-plane direction.

3. The prepreg according to claim 1, wherein the prepreg has an existing ratio of the impregnated region obtained by the following calculation method of 30 to 98%:
calculation method: a surface of the prepreg is observed with an optical microscope at a magnification of 50 times to obtain a surface observation image; the resulting surface observation image is converted to monochrome mode with image editing software, and saved in BMP (Microsoft Windows Bitmap Image) format; subsequently, the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

4. The prepreg according to claim 3, wherein the existing ratio of the impregnated region is 50 to 90%.

5. The prepreg according to claim 1, wherein the fiber substrate has a thickness of 70 to 120 µm.

6. A laminate comprising one or more plies of the prepreg according to claim 1.

7. A metal-clad laminate comprising a metal foil and one or more plies of the prepreg according to claim 1.

8. A printed wiring board comprising the laminate according to claim 6 or the metal-clad laminate according to claim 7.

9. A semiconductor package comprising the printed wiring board according to claim 8, and a semiconductor element.

10. A method for producing a prepreg having a surface waviness (Wa) of 5.0 µm or less by impregnating a fiber substrate having a thickness of 40 µm or more with a film of a thermosetting resin composition through lamination, the method comprising providing in the fiber substrate an impregnated region and a non-impregnated region with the thermosetting resin composition, and allowing the non-impregnated region to intermittently exist.

11. The method for producing a prepreg according to claim 10, wherein the non-impregnated region is allowed to intermittently exist in an in-plane direction.

12. The method for producing a prepreg according to claim 10, wherein the prepreg has an existing ratio of the impregnated region obtained by the following calculation method of 30 to 98%:
calculation method: a surface of the prepreg is observed with an optical microscope at a magnification of 50 times to obtain a surface observation image; the resulting surface observation image is converted to monochrome mode with image editing software, and saved in BMP (Microsoft Windows Bitmap Image) format; subsequently, the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

13. A method for producing a metal-clad laminate, comprising disposing metal foils on both surfaces of one ply of a prepreg obtained by the production method according to claim 10, or on both surfaces of a prepreg laminate including at least one or more plies of the prepreg, and then press-molding.
